# EUROPÄISCHE PATENTSCHRIFT

(11) **EP 0 344 764 B1**
(45) Veröffentlichungstag und Bekanntmachung des Hinweises auf die Patenterteilung: **31.08.1994**
(21) Anmeldenummer: 89109886.5
(22) Anmeldetag: 01.06.1989
(51) Int. Cl.: H01L 21/306

(54) **Verfahren zur nasschemischen Oberflächenbehandlung von Halbleiterscheiben**
Process for the wet-chemical surface treatment of semiconductor chips
Procédé de traitement de surface de plaquettes semi-conductrices par voie chimique humide

(30) Priorität: 01.06.1988 DE 3818714
(43) Veröffentlichungstag der Anmeldung: 06.12.1989
(73) Patentinhaber: Wacker-Chemitronic Gesellschaft für Elektronik-Grundstoffe mbH, D-84489 Burghausen (DE)
(72) Erfinder: Lampert, Ingolf, D-8263 Burghausen (DE); Gratzl, Christa, D-8265 Neuötting (DE)

(56) Entgegenhaltungen:
- US-A- 4 264 374
- US-A- 4 605 479
- PATENT ABSTRACTS OF JAPAN, Band 12, Nr. 13 (E-573), 14. Januar 1988; & JP-A-62 173 720
- ESC FALL MEETING, Band 87-2, Oktober 1987, Seite 900; C. McCONNELL: "New solutions for automated wet processing"
- EXTENDED ABSTRACTS/SPRING MEETING, Band 88-1, Mai 1988, Seite 389; G.T. DURANKO et al.: "Studies of Anhydrous HF Preoxidation Treatment of Silicon Surfaces"
- PATENT ABSTRACTS OF JAPAN, Band 6, Nr. 254 (E-148) 14. Dezember 1982; & JP-A-57 154 836

## Beschreibung

Die Erfindung betrifft ein Verfahren zur naßchemischen Oberflächenbehandlung von Halbleiterscheiben, bei dem wässrige, eine oder mehrere chemisch wirksame Substanzen gelöst enthaltende Phasen zur Einwirkung auf die Oberflächen gebracht werden.

Die ständig steigende Miniaturisierung bei der Herstellung von elektronischen Bauelementen hat immer höhere Anforderungen an die Oberflächenqualität der in der Regel in Scheibenform verwendeten Halbleitermaterialien wie insbesondere Silicium, aber auch Germanium, Galliumarsenid, oder Indiumphosphid zur Folge. Dies gilt nicht nur für die geometrische Qualität der Oberflächen, sondern auch für ihre Reinheit, chemische Beschaffenheit und Partikelfreiheit.

Um diese Parameter in reproduzierbarer Weise beeinflussen und steuern zu können, wurden Reinigungsverfahren entwikkelt, bei denen im Anschluß an einen Poliervorgang, durch den die geometrische Perfektion der Halbleiteroberflächen gewährleistet wird, eine Abfolge von Behandlungsschritten durchgeführt wird, bei denen verschiedene wässrige Agentien auf die Oberflächen einwirken. Die meisten dieser Verfahren gehen im wesentlichen auf einen Reinigungsprozeß zurück, der von W. Kern und D.A. Puotinen in RCA Reviews 31, 187 (1970) angegeben wurde, und aus einer Folge von Spül-, Hydrophilierungs- und Hydrophobierungsschritten besteht. Als Agentien kommen zumeist wässrige Lösungen von Ammoniak, Chlorwasserstoff, Fluorwasserstoff und als oxidierende Komponente Wasserstoffperoxid zum Einsatz.

Es ist dabei unerläßlich, daß die verwendeten Lösungen strengste Reinheitskriterien erfüllen, sei es in Bezug auf den Fremdionenanteil oder die Partikelfreiheit. Aus diesem Grund werden die Lösungen mit großem Aufwand bereits bei ihrer Herstellung durch Filtrationsvorgänge von den Partikeln so weit als möglich befreit, dann in speziellen Behältnissen transportiert und schließlich unter besonderen Vorkehrungen in die vorgesehenen Reinigungsbäder oder Sprühanlagen bzw. vorgeschaltete Reservoirs eingefüllt, wobei auch in den vorhandenen Zu- bzw. Ableitungen zusätzliche Filtrationseinrichtungen vorgesehen werden können.

Nachteilig wirkt sich dabei zum einen aus, daß die fertigen Lösungen bisweilen in großen Mengen und über weite Strecken transportiert werden müssen, was aufwendig ist und die Kontaminationsgefahr erhöht. Darüber hinaus ist der Einsatz insbesondere in den Fällen umständlich, in denen mehrere Behandlungsschritte mit verschiedenen Lösungen nacheinander durchgeführt werden, da eine entsprechend große Anzahl von Tauchbädern vorgelegt werden muß, deren Zusammensetzung darüber hinaus wegen der chemischen Reaktionen mit den Substraten und/oder der Flüchtigkeit der chemisch wirksamen Substanzen Schwankungen unterworfen ist. Bei den bekannten Sprühreinigungsprozessen ist eine umfangreiche Vorratshaltung für die verschiedenen Lösungen erforderlich. Darüber hinaus müssen in aufwendigen zwischengeschalteten Waschschritten insbesondere in den Zuleitungen jeweils die Rückstände des vorhergegangenen Behandlungsschrittes entfernt werden, ehe der nächste Schritt eingeleitet werden kann.

Die Aufgabe der Erfindung lag darin, ein Verfahren der eingangs genannten Art anzugeben, das einerseits die Probleme bei der Bereitstellung partikelfreier Lösungen vermeidet und eine einfache, rasche und wirksame Durchführung von auf die Oberfläche von Halbleiterscheiben einwirkenden Behandlungsschritten gestattet.

Gelöst wird die Aufgabe durch ein Verfahren, welches dadurch gekennzeichnet ist, daß in ein die zu behandelnden Halbleiterscheiben enthaltendes System die chemisch wirksamen Substanzen in gasförmigem und das Wasser in feinverteiltem flüssigem Zustand eingeleitet und die auf die Oberflächen einwirkenden Phasen unmittelbar im System durch Zusammenwirken der Gas- und der flüssigen Phase gebildet werden.

Die Möglichkeit, derartige naßchemische Prozesse bei der Scheibenreinigung durch den Einsatz von Gasen zu unterstützen, ist zwar allgemein in dem Abstract No. 640 der Extended Abstracts ECS Fall Meeting, Oct. 18-23, 1987, S. 900, New Solutions for Automatic Wet Processing, Verfasser Chris McConnell, angesprochen. In diesem Dokument werden jedoch keine konkreten Angaben zur Durchführung solcher Prozesse gemacht, sondern auf die noch erforderlichen Forschungsanstrengungen verwiesen.

Das bei dem erfindungsgemäßen Verfahren verwendete Wasser wird in möglichst hoher Reinheit eingesetzt, um eine Verunreinigung der Scheibenoberfläche zu vermeiden. Wasser ausreichender Reinheit kann beispielsweise in bekannter Weise durch Reinigung mittels Umkehrosmose, Ultrafiltration oder Ionenaustausch erhalten werden; es wird bei den derzeit üblichen Reinigungsprozessen beispielsweise für dazwischengeschaltete Spülschritte eingesetzt. Wichtige Kenngrößen für die Beurteilung der Qualität von bei der Herstellung von elektronischen Bauelementen verwendetem Wasser sind Ionen-, Partikel- und Bakterienfreiheit sowie der Gehalt an organisch gebundenem Kohlenstoff. Allgemein wird man die Erfordernisse an die Reinheit und Kontaminationsfreiheit des jeweils eingesetzten Wassers nach Maßgabe der an die behandelten Scheiben gestellten Reinheitsanforderungen an Hand einer oder mehrerer dieser bekannten Kenngrößen beurteilen. In vielen Fällen geht jedoch die Tendenz dahin, Stoffe in der jeweils maximal möglichen Reinheit einzusetzen.

Die Wassertemperatur kann innerhalb eines weiten Bereiches variiert werden und liegt im allgemeinen zwischen 10 und 90 °C. In manchen Fällen kann das Wasser ohne zusätzliche Kühl- oder Wärmebehandlung eingesetzt werden, d.h. bei Temperaturen von etwa 15 bis 25 °C. Zumeist wird das Wasser jedoch auf Temperaturen im Bereich von 35 bis 75 °C gehalten, z.B. durch Thermostatisieren, da sich dann kürzere Behandlungszeiten erzielen lassen.

Das Wasser wird in das System, das die zu reinigenden Scheiben aufgenommen hat, in feinverteilter Form eingebracht, d.h. beispielsweise eingesprüht, eingedüst oder vernebelt. Zu diesem Zweck eignen sich z.B. Düsensysteme, wie sie in den bekannten Sprühätz- oder Sprühreinigungsverfahren zum Aufbringen der Agentien auf die zu behandelnden Halbleiterscheiben verwendet werden. Vorteilhaft werden Tröpfchengröße, Einstrahlrichtung und Einstrahlstärke so aufeinander abgestimmt, daß sich zumindest im Bereich, in dem die Halbleiterscheiben vorgelegt sind, ein gleichmäßiger aerosolartiger Wassernebel aufbaut, so daß eine gleichmäßige Einwirkung auf die Scheibenoberfläche gewährleistet ist.

Als gasförmig zugeführte chemisch wirksame Substanzen kommen solche in Frage, die mit dem feinverteilten Wasser unter Bildung von auf der Scheibenoberfläche wirksamen Phasen zusammenwirken können. Bevorzugte Beispiele für solche Gase sind Ammoniak, Chlorwasserstoff, Fluorwasserstoff und Ozon oder ozonisierter Sauerstoff. Diese Gase können dabei sowohl in reiner Form als auch als Beimischung zu Trägergasen wie etwa Stickstoff, Argon oder ggf. auch Wasserstoff eingesetzt werden, wobei jedoch die Möglichkeit von Reaktionen zu berücksichtigen ist. Auch Luft kann grundsätzlich als Trägergas verwendet werden, sofern durch entsprechende Behandlung die erforderliche Reinheit und Partikelfreiheit sichergestellt ist.

Ammoniakgas, Chlorwasserstoffgas und Fluorwasserstoffgas sind in ausreichender chemischer Reinheit im Handel beispielsweise in den bekannten Stahlflaschen unter Druck erhältlich und lassen sich nötigenfalls durch in den Gasstrom eingeschaltete Filter, wie etwa Membranfilter aus inerten Materialien, z.B. Kunststoffen wie Polytetrafluorethylen, und mit entsprechend ausgewählten Porengrößen, von mitgeführten Partikeln befreien. Im allgemeinen zeichnen sich solche, in den Flaschen zumeist in verflüssigter Form vorliegende Gase durch eine hohe Reinheit aus, da viele Verunreinigungen in der flüssigen Phase und damit in der Gasflasche verbleiben. Bisweilen fallen geeignete Gase auch bei anderen Prozessen in ausreichender chemischer Reinheit als Abgase oder Nebenprodukte an und können so einer Verwendung zugeführt werden. Ein Beispiel dafür ist der bei der Siliciumherstellung durch Zersetzung von Trichlorsilan anfallende Chlorwasserstoff, der sich durch einen äußerst geringen Fremdionenanteil auszeichnet und daher besonders gut für Einsätze geeingnet ist, bei denen es auf höchste Reinheit ankommt. Allgemein kann bei den eingesetzten Gasen die Partikelanzahl mit gegenüber Flüssigkeiten verhältnismäßig geringem Aufwand bis auf Werte gebracht werden, die selbst den strengsten bei der Herstellung elektronischer Bauelemente für Reinräume gebräuchlichen Anforderungen entspricht. Beispielsweise bedeutet Reinraumklasse 10, daß die Anzahl der Partikel mit einer Größe von mehr als 0.3 µ m pro Kubikfuß der Atmosphäre höchstens 10 beträgt. Die Partikelanzahl in Gasströmen kann z.B. mittels Zählgeräten, die beispielsweise auf dem Prinzip der Streulichtmessung beruhen, überwacht werden.

Als oxidierendes Gas, dessen Wirkung mit der des Wasserstoffsuperoxids bei den herkömmlichen Prozessen vergleichbar ist, wird mit besonderem Vorteil Ozon oder ozonisierter Sauerstoff eingesetzt. In vielen Fällen ist dabei ein Ozongehalt von 0.5 bis 15 Vol%, bezogen auf den Gesamtgasstrom, ausreichend, wobei jedoch der Einsatz von Gasströmen mit demgegenüber höherem oder niedrigerem Ozonanteil nicht ausgeschlossen ist. Ozonhaltiger Sauerstoff kann in einfacher Weise mit Hilfe von sog. Ozonisatoren hergestellt werden, also handelsüblichen Geräten, in denen durchströmender Sauerstoff beispielsweise unter dem Einfluß von elektrischen Glimmentladungen teilweise in Ozon umgewandelt wird. Mit derartigen Geräten lassen sich meist Ozongehalte bis zu etwa 15 Vol%, bezogen auf Sauerstoff, erzielen. Höhere Ozongehalte zwischen typisch 20 und 30 Vol% lassen sich auch mit manchen mit speziellen Elektroden ausgerüsteten Elektrolysegeräten erhalten. Im Rahmen der Erfindung können solche ozonhaltige Gase sowohl einzeln für sich, als auch gleichzeitig mit einer oder mehreren der anderen genannten gasförmigen chemisch wirksamen Substanzen eingesetzt werden. Dabei sind allerdings zwischen den einzelnen Komponenten ablaufende Redoxreaktionen, wie beispielsweise zwischen Ozon und Ammoniak, in Betracht zu ziehen, welche in Konkurrenz zu den eigentlich erwünschten Reaktionen mit der Scheibenoberfläche treten können.

Als weitere oxidierende Gase können ergänzend oder alternativ insbesondere die Halogene Chlor und Brom eingesetzt werden, die wie die bereits genannten Gase ebenfalls leicht und in hoher Reinheit zugänglich und verfügbar sind und im Zusammenspiel mit Wasser auf der Scheibenoberfläche chemisch wirksam werden können.

Als System, in dem Wasser, gasförmige chemisch wirksame Substanzen sowie die Oberfläche der Halbleiterscheiben miteinander in Wechselwirkung treten können, eignen sich grundsätzlich Reaktionsräume, die das Einbringen einzelner oder mehrerer Halbleiterscheiben in eine Arbeitsposition, die gleichzeitige und gezielte Zufuhr von feinverteiltem Wasser und gasförmigen chemisch wirksamen Substanzen und deren gleichmäßige Einwirkung auf die Scheibenoberflächen, das Auffangen und ggf. Entfernen der dabei anfallenden Flüssigkeiten sowie nach Abschluß der Behandlung die Entnahme der Scheiben und ggf. das Einbringen einer weiteren Charge gestatten. Gegebenenfalls können auch Möglichkeiten vorgesehen werden, die Scheiben in der Arbeitsposition zu bewegen, beispielsweise durch Rotation. Geeignete Reaktionsräume können in der Art der bekannten Sprühätz- oder Sprühreinigungskammern gestaltet sein, wobei zweckmäßig anstelle der Einleitungsmöglichkeiten für die verschiedenen Lösungen entsprechende Einrichtungen für die Zufuhr der verschiedenen Gase und des Wassers vorgesehen werden. Grundsätzlich ist es jedoch auch möglich, gemischte Systeme zu betreiben, die sowohl über die Möglichkeit zur Einleitung von Gasen als auch von Lösungen verfügen, beispielsweise wenn bestimmte Mischungen eingesetzt werden sollen, die sich über die Gasphase nicht oder nur schwer herstellen lassen, wie etwa Wasserstoffperoxid/Ammoniak- oder Wasserstoffperoxid/Chlorwasserstofflösungen.

Zweckmäßig werden die anfallenden wässrigen Phasen nach ihrer Einwirkung auf die Scheibenoberfläche möglichst rasch aus dem System entfernt, um etwaige Störungen der sich zwischen fester, flüssiger und Gasphase einstellenden Gleichgewichte zu verhindern und/oder Verunreinigungen abzuführen, die bei dem Prozeß aufgenommen werden. Dieses Verfahren hat sich in den meisten Fällen als günstiger erwiesen, als die verbrauchten Flüssigkeiten im System zu sammeln und portionsweise abzuführen, obwohl auch diese Variante grundsätzlich nicht ausgeschlossen ist.

Die letztendlich auf der Scheibenoberfläche wirksamen Konzentrationen der gasförmig eingespeisten chemisch wirksamen Substanzen im Zusammenwirken mit dem feinverteilten Wasser können durch die jeweils eingestellten Mengen- bzw. Volumenanteile beeinflußt werden, in denen die Komponenten in der Zeiteinheit in das System einströmen. Zweckmaßig werden die optimalen Werte an Hand von Vorversuchen ermittelt. Als Richtwerte können die Konzentrationen dienen, die bei den herkömmlichen reinen Flüssigprozessen für die entsprechenden Lösungen eingestellt werden. Aus diesen Konzentrationen lassen sich dann in erster Näherung die Mengenverhältnisse und die entsprechenden Durchflußraten ableiten, in denen die Komponenten jeweils im System bereitgestellt werden müssen. Beispielsweise werden im Falle einer herkömmlicherweise eingesetzten ca. 10 gew%igen Salzsäurelösung die in der Zeiteinheit dem System zugeführten Mengen an Chlorwasserstoffgas und an feinverteiltem Wasser auf ein Gewichtsverhältnis von etwa 1:9 eingestellt. Ausgehend von diesen Werten kann dann ggf. noch eine Feinabstimmung erfolgen.

Mit Hilfe des erfindungsgemäßen Verfahrens lassen sich Reinigungsprozesse, bei denen die Oberfläche von polierten Halbleiterscheiben zur Entfernung von restlichen kontaminierenden Teilchen und zur Einstellung bestimmter Oberflächeneigenschaften naßchemisch behandelt wird, in besonders einfacher und eleganter Weise durchführen. Eine mögliche Abfolge von Prozeßschritten, bei der die Oberflächen von Halbleiterscheiben zunächst von etwaigen Polierrückständen befreit und schließlich in einen hydrophilen Zustand versetzt werden, kann beispielsweise folgendermaßen ablaufen: Zunächst werden die Scheiben z.B. in einer Prozeßhorde in das System, beispielsweise eine umgerüstete Sprühätzkammer, eingebracht, wo mittels mehrerer Düsensysteme ein kontinuierlicher Wassernebel erzeugt wird. Durch kurzzeitiges Einspeisen von Fluorwasserstoffgas wird im System Flußsäure gebildet, die von der Scheibenoberfläche eine etwa gebildete Oxidschicht mitsamt den darin enthaltenen Verunreinigungen ablöst. Nach Beendigung der HF-Einleitung und unter fortgesetztem Einsprühen von Wasser werden die Scheiben säurefrei gewaschen und dann dem System kurzzeitig ein ozonisierter Sauerstoffstrom zugemischt, der erneut die Bildung einer oberflächlichen Oxidschicht bewirkt. Danach werden die Scheiben im zusatzfreien Wassernebel gewaschen, dann durch erneute HF-Einleitung ins System die Oxidschicht abgelöst und schließlich nach einem weiteren Waschschritt durch Einleiten von ozonisiertem Sauerstoff und Chlorwasserstoffgas eine hydrophile Scheibenoberfläche erzeugt, wobei abschliessend durch einen Waschschritt die letzten Reste der chemisch aktiven Substanzen aus dem System entfernt werden. Anschließend können die Scheiben zur Trocknung entnommen oder aber im System beispielsweise im Stickstoff- oder Argonstrom, ggf. auch bei erhöhter Temperatur, getrocknet werden. Es ist selbstverständlich, daß dieser hier erläuterte Prozeß nicht im Sinne einer Beschränkung des Erfindungsgedankens zu sehen ist, sondern nur beispielhaft eine der vielen möglichen Ausführungsformen aufzeigen soll.

Der Vorteil des erfindungsgemäßen Verfahrens liegt nicht nur in der hohen Partikelfreiheit der auf die Scheiben einwirkenden Agentien, dank der für Gase erheblich höher entwickelten Reinigungstechnik. Auch die Vorratshaltung ist mit deutlich weniger Aufwand verbunden, da die chemisch wirksamen Substanzen nicht in Lösung, sondern in Gasform bereitgestellt werden können. Des weiteren sind derartige Systeme leicht steuerbar und können, z.B. durch den Einbau von rechnergesteuerten Magnetsystemen, automatisiert werden. Nicht zuletzt sind die Prozesse sehr leicht abzuändern und gestatten es, in flexibler Weise auf verschiedene Anforderungen zu reagieren, beispielsweise wenn hydrophobe anstatt hydrophiler Scheibenoberflächen erzeugt werden sollen, da nicht große entsprechend geänderte Lösungen hergestellt werden müssen. Insgesamt gesehen kann dadurch auch der Chemikalienbedarf und die anfallende Menge an zu entsorgenden Chemikalien verringert werden.

Das Verfahren eignet sich insbesondere zur naßchemischen Behandlung von Elementhalbleitern wie Germanium und vorzugsweise Silicium. Es kann jedoch auch bei Verbindungshalbleitern wie Galliumarsenid, Galliumphosphid, Indiumphosphid oder Cadmiumtellurid eingesetzt werden.

Nachstehend wird die Erfindung an Hand eines Ausführungsbeispiels näher erläutert:

In einer herkömmlichen, jedoch zur Gaseinleitung umgerüsteten Sprühreinigungskammer wurde an polierten Siliciumscheiben ein Reinigungsprozeß durchgeführt.

Die Kammer war zu diesem Zweck anstelle von Einleitungsmöglichkeiten für verschiedene Lösungen mit Gasanschlüssen zur Zuführung von Fluorwasserstoffgas, Chlorwasserstoffgas, ozonisiertem Sauerstoff und Argon versehen. Die einzelnen Gase wurden in Stahlflaschen bereitgestellt, über Druckminderer auf den Arbeitsdruck eingestellt und konnten über steuerbare Regelventile in bestimmten Durchflußraten in das Kammersystem eingespeist werden. Das Sauerstoffgas durchlief einen handelsüblichen Ozonisator, in dem es mit ca. 8 Vol% Ozon angereichert wurde.

Weiterhin konnte in die Kammer über ein Düsensystem Wasser in der Weise eingesprüht werden, daß sich im Innenraum ein homogener, aerosolartiger Sprühnebel aufbaute. Das eingesetzte Wasser war durch Umkehrosmose von Fremdionen und durch Ultrafiltration von Partikeln befreit und entsprach dem in der Halbleitertechnik für naßchemische Reinigungsprozesse mit Lösungen üblichen Reinheitsstandard.

In jeden der Gasströme war vor seinem Eintritt in die eigentliche Reinigungskammer ein Membranfilter aus Polytetrafluorethylen mit einer Porengröße von ca. 0.2 µ m eingeschaltet. Stichprobenartige Untersuchungen mittels Partikelzähler ergaben, daß die Gasströme nach der Filtration den Anforderungen der Reinraumklasse 10 genügten; d.h. sie enthielten maximal 10 Partikel mit mehr als 0.3 µ m Teilchengröße pro Kubikfuß.

Nun wurde eine mit ca. 25 polierten Siliciumscheiben (Durchmesser ca. 10 cm) bestückte Prozeßhorde auf den im System befindlichen Drehteller aufgelegt und in Drehung versetzt, so daß die Scheiben in der Längsachse der Sprühkammer rotierten. Gleichzeitig wurde mit dem Einsprühen des Wassers begonnen, wodurch die Scheiben rasch von einem dichten Wassernebel umgeben wurden. Die Temperatur des Wassers betrug ca. 60°C. Nach etwa 20 Sekunden wurde das Ventil für Fluorwasserstoffgas geöffnet und HF-Gas eingeleitet, wobei dessen Durchflußrate und die des Wassers so aufeinander abgestimmt wurden, daß die im System in der Zeiteinheit jeweils vorhandenen Mengen beider Stoffe einer ca. 0.5 gew%igen Flußsäure entsprachen. Nach etwa 60 sec wurde der Gasstrom unterbrochen, und für ca. 100 sec nur Wasser auf die Scheiben gesprüht. Danach wurde unter fortgesetzter Wasserzufuhr für ca. 120 sec in die Behandlungskammer Chlorwasserstoffgas (ca. 5 Gew%, bezogen auf Wasser) und ozonisierter Sauerstoff (ca. 1l Gasgemisch pro l Wasser) eingeleitet. Daran schloß sich ein 180 sec dauernder Spülschritt mit reinem Wasser ohne Gaszusatz an. Nun wurde erneut für ca. 60 sec Fluorwasserstoffgas eingeleitet, und zwar in der bereits vorher verwendeten Durchflußrate. (Eine solche Vorgehensweise ist nicht zwingend vorgeschrieben; es können auch jeweils verschiedene Durchflußraten zum Einsatz kommen) Daraufhin wurde wieder für etwa 100 sec nur mit Wasser gespült und schließlich für weitere 60 sec zusätzlich ozonisierter Sauerstoff eingeleitet, und zwar wieder so, daß pro l Wasser auch etwa 1l Gasgemisch eingespeist wurde. Schließlich wurde sowohl der Gas- als auch der Wasserstrom gestoppt und die Scheiben trockengeschleudert, wobei der Trockenvorgang durch einen Argonstrom unterstützt wurde.

Die erhaltenen hydrophilen Siliciumscheiben wurden entnommen und mit Hilfe der sog. VPD/AAS-Analysenmethode auf Oberflächenverunreinigungen untersucht. Diese Untersuchungsmethode ist in "Chemical Analysis of Ultratrace Impurities in SiO₂ Films", A. Shimazaki et al., Extended Abstracts of the 16th Conference on Solid State Devices and Materials, Kobe 1984, Seite 281-284 beschrieben und gestattet die Erfassung geringster Verunreinigungsmengen. Die Untersuchung erbrachte das folgende durchschnittliche Ergebnis (Angaben jeweils in Atomen/cm²):
Eisen: weniger als 7.0 x 10¹⁰
Chrom: weniger als 7.5 x 10¹⁰
Aluminium: 5.4 x 10¹¹
Zink: 1.4 x 10¹¹
Diese Werte entsprachen damit den besten mit den herkömmlichen, mit wässrigen Lösungen durchgeführten Bad- oder Sprühreinigungsprozessen erzielbaren Reinheitsstufen.

## Patentansprüche

1. Verfahren zur naßchemischen Oberflächenbehandlung von Halbleiterscheiben, bei dem wässrige, eine oder mehrere chemisch wirksame Substanzen gelöst enthaltende Phasen zur Einwirkung auf die Oberflächen gebracht werden, dadurch gekennzeichnet, daß in ein die zu behandelnden Halbleiterscheiben enthaltendes System die chemisch wirksamen Substanzen in gasförmigem und das Wasser in feinverteiltem flüssigem Zustand eingeleitet und die auf die Oberflächen einwirkenden Phasen unmittelbar im System durch Zusammenwirken der Gas- und der flüssigen Phase gebildet werden.

2. Verfahren nach Anspruch 1, dadurch gekennzeichnet, daß das Wasser als Sprühnebel in das System eingeleitet wird.

3. Verfahren nach den Ansprüchen 1 oder 2, dadurch gekennzeichnet, daß das Wasser auf eine Temperatur von 10 bis 90°C eingestellt wird.

4. Verfahren nach einem oder mehreren der Ansprüche 1 bis 3, dadurch gekennzeichnet, daß die chemisch wirksamen Substanzen ausgewählt werden aus der Gruppe der Gase Ammoniak, Chlorwasserstoff, Fluorwasserstoff, Ozon bzw. ozonisierter Sauerstoff, Chlor oder Brom.

5. Verfahren nach einem oder mehreren der Ansprüche 1 bis 4, dadurch gekennzeichnet, daß das Wasser und die chemisch wirksamen Substanzen vor dem Einsatz einer die Partikelzahl reduzierenden Behandlung unterzogen werden.

6. Verfahren nach einem oder mehreren der Ansprüche 1 bis 5, dadurch gekennzeichnet, daß als zu behandelnde Halbleiterscheiben Siliciumscheiben eingesetzt werden.

7. Verfahren nach einem oder mehreren der Ansprüche 1 bis 6, dadurch gekennzeichnet, daß in das System ein kontinuierlicher Strom feinverteilten Wassers und eine Abfolge von gasförmigen chemisch wirksamen Substanzen eingeleitet wird.

8. Verfahren nach Anspruch 7, dadurch gekennzeichnet, daß die Abfolge so eingestellt wird, daß zwischen der periodischen Einleitung der chemisch wirksamen Substanzen Wasser auf die zu behandelnden Halbleiterscheiben einwirkt.

## Claims

1. Process for the wet-chemical surface treatment of semiconductor wafers in which aqueous phases containing one or more chemically active substances in solution are caused to act on the surfaces, characterized in that the chemically active substances are introduced in the gaseous state and the water in the finely divided liquid state into a system containing the semiconductor wafers to be treated and the phases acting on the surfaces in the system itself are formed by the interaction of the gas phase and the liquid phase.

2. Process according to Claim 1, characterized in that the water is introduced into the system as a spray mist.

3. Process according to Claims 1 or 2, characterized in that the water is adjusted to a temperature of 10 to 90°C.

4. Process according to one or more of Claims 1 to 3, characterized in that the chemically active substances are selected from the group comprising the gases ammonia, hydrogen chloride, hydrogen fluoride, ozone or ozonized oxygen, chlorine or bromine.

5. Process according to one or more of Claims 1 to 4, characterized in that the water and the chemically active substances are subjected to a treatment which reduces the number of particles before use.

6. Process according to one or more of Claims 1 to 5, characterized in that silicon wafers are used as semiconductor wafers to be treated.

7. Process according to one or more of Claims 1 to 6, characterized in that a continuous stream of finely divided water and a sequence of gaseous, chemically active substances are introduced into the system.

8. Process according to Claim 7, characterized in that the sequence is so adjusted that water acts on the semiconductor wafers to be treated between the periodic introduction of the chemically active substances.

## Revendications

1. Procédé pour traiter par voie chimique humide les surfaces de plaques de semi-conducteurs, dans lequel on fait agir sur les surfaces des phases aqueuses qui comportent à l'état dissous une ou plusieurs substances chimiquement actives, caractérisé en ce que l'on introduit, dans un système qui contient les plaques de semi-conducteurs à traiter, les substances chimiquement actives sous forme gazeuse et l'eau sous une forme liquide finement divisée, et en ce que l'on forme les phases agissant sur les surfaces immédiatement dans le système, par réaction de la phase gazeuse et de la phase liquide.

2. Procédé selon la revendication 1, caractérisé en ce que l'eau est introduite dans le système sous forme d'un brouillard de pulvérisation.

3. Procédé selon les revendications 1 ou 2, caractérisé en ce que l'eau est réglée à une température de 10 à 90°C.

4. Procédé selon une ou plusieurs des revendications 1 à 3, caractérisé en ce que les substances chimiquement actives sont choisies dans le groupe des gaz suivants : l'ammoniac, l'acide chlorhydrique, l'acide fluorhydrique, l'ozone ou l'oxygène ozonizé, le chlore ou le brome.

5. Procédé selon une ou plusieurs des revendications 1 à 4, caractérisé en ce que l'eau et les substances chimiquement actives sont soumises, avant leur utilisation, à un traitement pour réduire le nombre des particules.

6. Procédé selon une ou plusieurs des revendications 1 à 5, caractérisé en ce que, comme plaques de semi-conducteurs à traiter, on utilise des plaques de silicium.

7. Procédé selon une ou plusieurs des revendications 1 à 6, caractérisé en ce que l'on introduit dans le système un courant continu d'eau finement divisée et une suite de substances gazeuses chimiquement actives.

8. Procédé selon la revendication 7, caractérisé en ce que la suite est réglée de telle sorte qu'entre l'introduction périodique des substances chimiquement actives, l'on fait agir de l'eau sur les plaques de semi-conducteurs à traiter.
